# EUROPEAN PATENT APPLICATION

(11) **EP 4 600 746 A1**
(43) Date of publication of application: **13.08.2025**
(21) Application number: 24157102.5
(22) Date of filing: 12.02.2024
(51) Int. Cl.: G03F 7/20

(54) **AN ILLUMINATION AND DETECTION ARRANGEMENT AND A METHOD FOR A METROLOGY ARRANGEMENT**

(71) Applicant: ASML Netherlands B.V., 5500 AH Veldhoven (NL)
(72) Inventor: WARNAAR, Patrick, 5500 AH Veldhoven (NL); PELLEMANS, Henricus, Petrus, Maria, 5500 AH Veldhoven (NL)
(74) Representative: ASML Netherlands B.V.

(57) **Abstract**

Disclosed is an illumination and detection arrangement for a lithographic or inspection apparatus, comprising: a plurality of individually configurable illumination sources located in an illumination plane, each being operable to emit illumination radiation; an objective lens defining an objective NA area and configured to receive the illumination radiation, focus it onto a structure in an object plane, and subsequently collect radiation scattered from the structure upon illumination; and at least one image sensor located in a detection plane and configured to detect at least one portion of the scattered radiation collected by the objective lens and record an image associated with the structure; wherein the at least one portion of the scattered radiation either is detected at or passes through the illumination plane.

## Description

### FIELD

The present invention relates to an illumination and detection arrangement and its use in a metrology arrangement, and a method for illuminating and detecting radiation in a metrology arrangement.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable to make frequently measurements of the structures created, e.g., for process control and verification. Various tools for making such measurements are known, including scanning electron microscopes or various forms of metrology apparatuses, such as scatterometers. A general term to refer to such tools may be metrology apparatuses or inspection apparatuses.

Existing metrology tools (e.g., scatterometers) typically use separate optical branches for, amongst others, illumination and detection and each of those separate optical branches may consist of many different components or parts. Consequently, existing illumination branches or systems are expensive, are not compact and are complex, and therefore unreliable. Therefore, it is desirable to simplify the design of the illumination and detection branches or systems so as to further improve the performance and/or reduce cost of existing metrology tools.

### SUMMARY

Embodiments of the invention are disclosed in the claims and in the detailed description.

In a first aspect of the invention there is provided an illumination and detection arrangement for a metrology arrangement, comprising: a plurality of individually configurable illumination sources located in an illumination plane, wherein each of the plurality of individually configurable illumination sources is operable to emit illumination radiation; an objective lens defining an objective NA area and configured to receive the illumination radiation, focus it onto a structure in an object plane, and subsequently collect radiation scattered from the structure upon illumination; and at least one image sensor located in a detection plane and configured to detect at least one portion of the scattered radiation collected by the objective lens and record an image associated with the structure; wherein the at least one portion of the scattered radiation either is detected at or passes through the illumination plane.

In a second aspect of the invention there is provided a metrology device comprising an illumination and detection arrangement of the first aspect, operable to use the plurality of individually configurable illumination sources to provide measurement illumination for a measurement of a structure and use the at least one image sensor to record an image of the structure. In some embodiments, the metrology device may comprise a scatterometer, interferometer or holographic microscope. In some embodiments, the metrology device may comprise an alignment sensor or level sensor.

**In** a third aspect of the invention there is provided a method for illuminating and detecting radiation in a metrology arrangement.

Other aspects of the invention comprise a lithographic device comprising an illumination and detection arrangement of the first aspect.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 is a schematic illustration of a scatterometry apparatus;
- Figure 5(a) is a schematic diagram of a dark field scatterometer for use in measuring targets according to embodiments of the invention using a first pair of illumination apertures;
- Figure 5(b) shows a detail of diffraction spectrum of a target grating for a given direction of illumination;
- Figure 5(c) shows a second pair of illumination apertures providing further illumination modes in using the scatterometer for diffraction based overlay measurements;
- Figure 5(d) shows a third pair of illumination apertures combining the first and second pair of apertures;
- Figure 5(e) shows further illumination aperture examples which may be used for other metrology applications;
- Figure 6(a) is a schematic diagram of an illumination and detection arrangement for a metrology arrangement in accordance with an embodiment;
- Figure 6(b) shows an objective NA area of the objective lens of the illumination and detection arrangement;
- Figure 6(c) shows an example arrangement of a plurality of individually configurable illumination sources and at least one image sensor, both located in an illumination plane;
- Figure 7(a) is a schematic diagram of an illumination and detection arrangement for a metrology arrangement in accordance with a different embodiment;
- Figure 7(b) shows an objective NA area of the objective lens of the illumination and detection arrangement; and
- Figure 7(c) shows an example arrangement of a plurality of individually configurable illumination sources and at least one pair of optical wedges, both located in an illumination plane.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

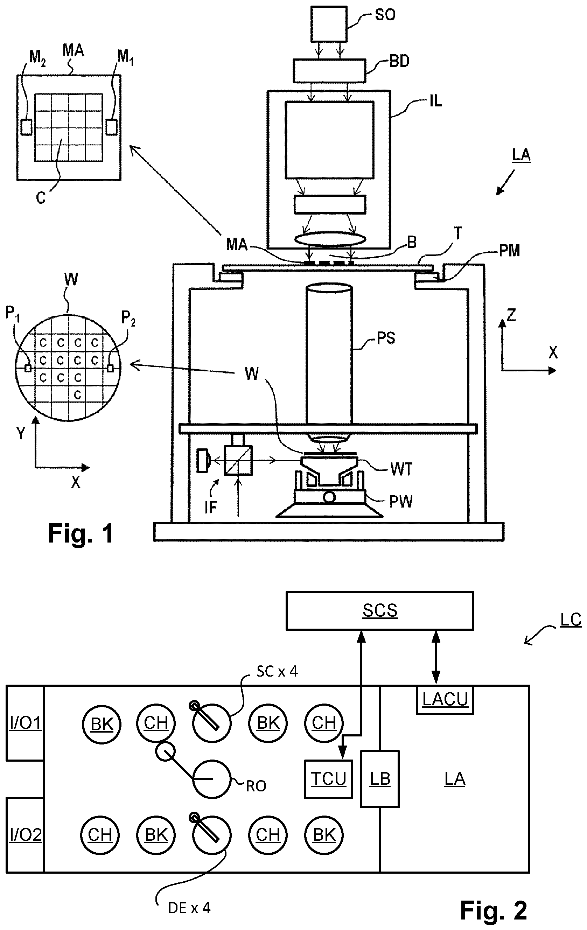

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US patent US6952253B2, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

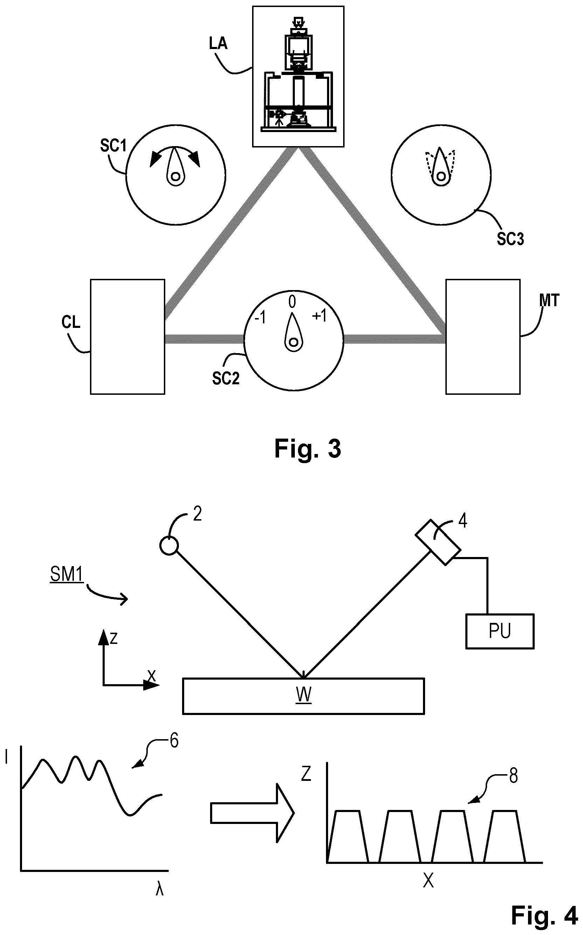

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MET (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second scale SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655A1, US2011102753A1, US20120044470A1, US20110249244A1, US20110026032A1 or EP1628164A2, incorporated herein by reference in their entirety. Aforementioned scatterometers can measure in one image multiple targets from multiple gratings using light from soft x-ray and visible to near-IR wave range.

A metrology apparatus, such as a scatterometer, is depicted in Figure 4. It comprises a broadband (white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation 10. From this data, the structure or profile 8 giving rise to the detected spectrum may be reconstructed by processing unit PU, e.g. by Rigorous Coupled Wave Analysis and non-linear regression or by comparison with a library of simulated spectra. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patents or applications US7791724B2, US7701577B2, US8115926B2, US8553227B2, US8681312B2, US8792096B2, US8823922B2, US8692994B2, US2013162996A1, and US8797554B2, which are incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1628164A2, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO2011012624A1 or US patent application US20160161863A1, incorporated herein by reference in its entirety. Other parameters of interest may be focus and dose. Focus and dose may be determined simultaneously by scatterometry (or alternatively by scanning electron microscopy) as described in US patent application US20110249244A1, incorporated herein by reference in its entirety.

The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US20160161863A1 and published US patent application US20160370717A1 incorporated herein by reference in its entirety.

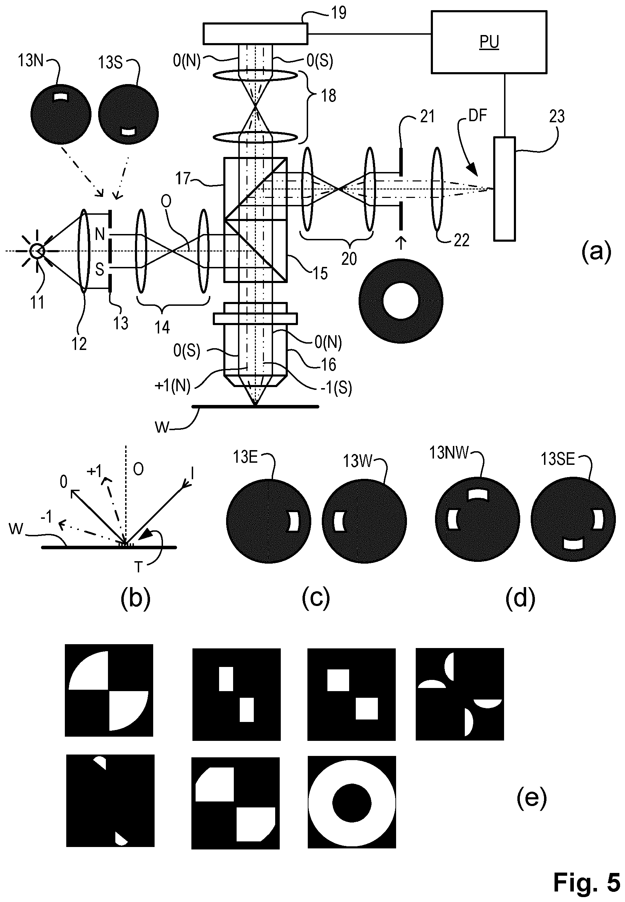

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figures 5(a) - 5(e) are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figures 5(a) - 5(e)) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

Figure 5(e) shows a number of other illumination apertures presently used in metrology. These are only a small sample of the illumination apertures presently used, but show that the apertures may differ significantly in size, shape and/or position depending on the specific application.

It is well known that different targets with different pitches and thin film layers have different optimum illumination pupil profiles. An optimized illumination pupil profile increases stack sensitivity and decreases stray light induced measurement errors. Such a flexible pupil profile also has benefits for applications with overall thicker layer-sets, such as 3D-NAND. The required illumination pupil profiles for these illumination modes are usually obtained by the placing of a suitable aperture plate (e.g., aperture plate 13 in Figure 5(a)) between the source and the target being measured. However, there can be many different illumination modes needed each requiring a different aperture plate. This ultimately puts a practical limit on the number of modes available. Additional flexibility can be obtained by using a Spatial Light Modulator (SLM). However, both aperture plates and SLMs reduce the amount of light available by ultimately blocking a portion of the light from the source.

Existing scatterometry-based metrology tools (e.g., as shown in Figure 5(a)) typically use separate optical branches for, amongst others, illumination and detection and each of those separate optical branches may consist of many different components or parts. For example, to provide different wavelengths and/or flexible illumination profiles, an existing illumination branch or system often comprises a color (or wavelength) switching module configured to define the illumination wavelength and/or bandwidth, and an illumination mode selecting module configured to define the distribution of the illumination radiation in the pupil plane. Such existing illumination branches or systems are expensive, are not compact and are complex.

The US patent US10180630B2, which is incorporated herein by reference, discloses an illumination system which is capable of mitigating one or more of the associated problems mentioned above. The illumination system comprises a plurality of illumination sources, such as a microLED array and provides a tunable-wavelength illumination pupil with control over the pupil profile. Comparing with conventional illumination systems (e.g., as shown in Figure 5(a)), the illumination system disclosed in US10180630B2 is more compact and has lower cost and higher reliability. However, such an improved illumination system is still physically separated from the detection branches (e.g., as shown in Figures 3(a) and 5 of US10180630B2) of the metrology system, thereby limiting the minimum achievable size and cost of the metrology tool. Therefore, it is desirable to further improve existing scatterometry-based metrology tools, particularly the illumination and detection systems comprised therein.

According to a first aspect of the present disclosure, there is provided an illumination and detection arrangement for a metrology arrangement, for a metrology device or lithographic device. The illumination and detection arrangement may comprise a plurality of individually configurable illumination sources located in an illumination plane. Each of the plurality of individually configurable illumination sources may be operable to emit illumination radiation. The illumination and detection arrangement may comprise an objective lens defining an objective NA area and configured to receive the illumination radiation, focus it onto a structure in an object plane, and subsequently collect radiation scattered from the structure upon illumination. The size (e.g., diameter) of the objective NA area may depend on the design of the objective lens. The illumination and detection arrangement may comprise at least one image sensor located in a detection plane and configured to detect at least one portion of the scattered radiation collected by the objective lens and record an image associated with the structure. The at least one portion of the scattered radiation may either be detected at or pass through the illumination plane.

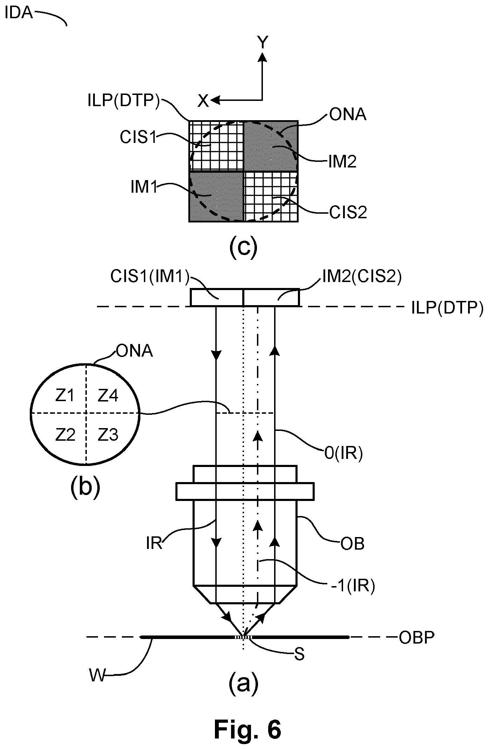

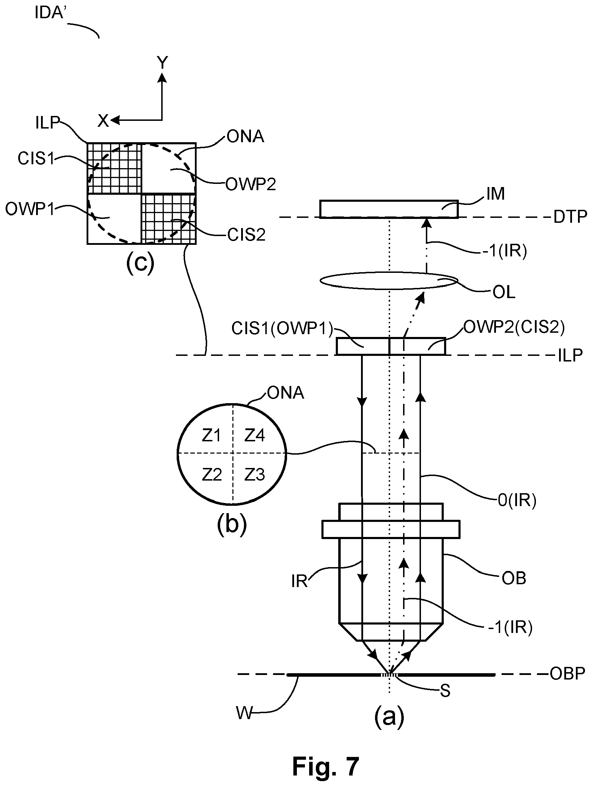

The illumination plane may be a plane substantially coplanar with a light emitting surface of plurality of individually configurable illumination sources. As such, the illumination radiation may originate from the illumination plane and follow an illumination optical path towards the structure, e.g., as indicated by the solid line in Figure 6 or 7. The detection plane may be a plane substantially coplanar with an image sensitive (or light sensitive) surface of the at least one image sensor. As such, the scattered radiation may originate from the structure and follow a detection optical path towards the detection plane, e.g., as indicated by the dashed and dotted line in Figure 6 or 7. The illumination plane and detection plane may be mutually parallel planes (i.e., including the possibility of the illumination plane being substantially coplanar with the detection plane). The illumination plane may be coplanar with the pupil plane of the objective lens or a conjugate plane thereof. Furthermore, the illumination optical path and the detection optical path can fully or partially overlap in the context of this document.

The objective NA area has a diameter corresponding to the width between two most oblique light rays captured by the objective lens, wherein the two most oblique light rays and the optical axis of the objective lens are in the same plane. Since the angle between each of the two most oblique light rays and the optical axis of the objective lens is determined by the objective NA, the objective NA area is therefore a fixed area and thus not plane-dependent. The objective NA area may comprise an illumination NA area and a detection NA area (i.e., the illumination NA area may pass illumination radiation in a first direction towards the object plane and the detection NA area may pass illumination radiation in a second direction (e.g., substantially opposite said first direction) towards the detection plane). The objective NA area may be divided (e.g., substantially equally) into said illumination NA area and said detection NA area; e.g., said illumination NA area and said detection NA area may be substantially complementary. In an embodiment, the illumination NA area may consist of at least one of two diagonally opposite portions of the objective NA area and the detection area may consist of at least one of the other two diagonally opposite portions of the objective NA area of the objective lens, although other arrangements are possible. In the context of this document it will be appreciated that a portion can take different shapes and sizes, for example a quadrant.

In an embodiment, the plurality of individually configurable illumination sources may be configured such that an entire of the illumination NA area is fillable by the illumination radiation.

In an embodiment where the illumination plane may be common (i.e., coplanar) with the detection plane, the plurality of individually configurable illumination sources may be spatially separate from the at least one image sensor. The at least one image sensor may be configured to detect the at least one portion of the scattered radiation after it has propagated through the detection NA area of the objective NA area.

Figures 6(a)-6(c) are associated with an embodiment where the illumination plane ILP is common (or coplanar) with the detection plane DTP. Figure 6(a) schematically illustrates an illumination and detection arrangement IDA in accordance with an embodiment. Figure 6(b) shows an objective NA area of the objective lens OB of the illumination and detection arrangement IDA. Figure 6(c) shows an example arrangement of the individually configurable illumination sources and the at least one image sensor, both located in an illumination plane ILP.

With reference to Figures 6(a) and 6(b), the illumination and detection arrangement IDA may comprise an objective lens OB which defines an objective NA area ONA. The objective NA area ONA may be divided into different portions, some of which may be used for illumination while others for detection. With reference to Figure 6(b), the objective NA area ONA may be divided into four equally sized quadrants, namely a first quadrant Z1, a second quadrant Z2, a third quadrant Z3 and a fourth quadrant Z4. It will be appreciated that in different embodiments, the objective NA area ONA may be divided into any other number of zones which may or may not have a same size or shape.

With reference to Figure 6(c), the plurality of the individually configurable illumination sources may comprise a first array of illumination sources CIS 1 which may be aligned with the first quadrant Z1 of the objective NA area ONA and a second array of illumination sources CIS2 which may be aligned with the third quadrant Z3 of the objective NA area ONA, the first quadrant Z1 and the third quadrant Z3 being diagonally opposite to each other. For example, the first array of illumination sources CIS1 may comprise an area equal to, smaller or larger than that of the first quadrant Z1 and the second array of illumination sources CIS2 may comprise an area equal to, smaller or larger than that of the third quadrant Z3. Each of the first array of illumination sources CIS 1 and the second array of illumination sources CIS2 may be configured to output a desired illumination profile. In other embodiments, the first array of illumination sources CIS 1 may be aligned with at least a first portion of the objective NA area and the second array of illumination sources CIS2 may be aligned with at least a second portion of the objective NA area, the at least a first portion and the at least a second portion being diagonally opposite to each other. Each of the at least a first portion and the at least a second portion may be of any shape and may be either larger or smaller than a quadrant of the objective NA area.

The at least one image sensor may comprise a first image sensor IM1 (e.g., a CCD or CMOS sensor) which may be aligned with the second quadrant Z2 of the objective NA area ONA and a second image sensor IM2 (e.g., a CCD or CMOS sensor) which may be aligned with the fourth quadrant Z4 of the objective NA area ONA, the second quadrant Z2 and the fourth quadrant Z4 being diagonally opposite to each other. For example, the first image sensor IM1 may comprise an area equal to, smaller or larger than that of the second quadrant Z2 and the second image sensor IM2 may comprise an area equal to, smaller or larger than that of the fourth quadrant Z4. As such, the illumination NA area of the objective NA area ONA may correspond to the first and third quadrants Z1, Z3 and the detection NA area of the objective NA area ONA may correspond to the second and fourth quadrants Z2, Z4. In other embodiments, the first image sensor IM1 may be aligned with at least a third portion of the objective NA area and the second image sensor IM2 may be aligned with at least a fourth portion of the objective NA area, the at least a third portion and the at least a fourth portion being diagonally opposite to each other. Each of the at least a third portion and the at least a fourth portion may be of any shape and may be either larger or smaller than a quadrant of the objective NA area.

The plurality of the individually configurable illumination sources CIS 1, CIS2 and the at least one image sensor IM1, IM2 may both be in the illumination plane ILP which may be coplanar with the pupil plane of the objective lens OB. In alternative embodiments, the plurality of the individually configurable illumination sources CIS1, CIS2 and the at least one image sensor IM1, IM2 may be in a conjugate plane of the pupil plane of the objective lens OB. This may be the case when the pupil plane of the objective lens OB is located within the body of the objective lens OB. As such, one or more optical elements (not shown) may be comprised between the objective lens OB and the plurality of the individually configurable illumination sources CIS1, CIS2 and the at least one image sensor IM1, IM2 (e.g., to form a conjugate plane of the pupil plane outside the body of the objective lens OB).

In an embodiment, the plurality of individually configurable illumination sources (e.g., CIS1, CIS2) and the at least one image sensor (e.g., IM1, IM2) may be comprised in a single integral device or module. In such a case, the illumination and detection arrangement IDA may further comprise a control unit (not shown) configured to control the operation of all the illumination sources (e.g., CIS1, CIS2) and image sensors (e.g., IM1, IM2). The control unit may be comprised in the single integral device. Alternatively, the control unit may be part of a control system of a metrology tool in which the illumination and detection arrangement IDA is comprised.

In an embodiment, the plurality of illumination sources (e.g., CIS1, CIS2) may be provided by one or more arrays of microLEDs (Light Emitting Diodes which may be inorganic LED or organic LED, i.e. OLED), wherein each microLED acts as one individually configurable illumination source, i.e. the light output of each microLED can be individually controlled. The output of each individually configurable microLED may comprise an output intensity, an output wavelength, an output bandwidth, and/or a polarization state. Each microLED may be of the size of e.g., around 20 µm and the light emitted from each microLED may have a centre wavelength in a range of e.g., 400 nm to 900 nm. The centre wavelength from each microLED may be individually configurable. It will be appreciated that depending on application, microLEDs with other different sizes and/or different wavelengths or wavelength ranges may be used. These numbers are typical examples and are not limiting. A desired pupil illumination profile may be set on the microLED arrays by selective activation of the microLEDs in order to define an output electromagnetic radiation profile.

MicroLED arrays may be defined by lithography steps, and have a large design freedom in dimension and layout. Referring to Figure 6(c), the first and second microLED arrays CIS 1, CIS2 may each have a rectangular shape. Alternatively, the first and second microLED arrays CIS 1, CIS2 may each have the shape of the corresponding one of the two diagonally opposite quadrants Z1, Z3. Additionally, different LED diameters can be used (for example from ^{~}1 µm upwards) at different locations, and their spacing can be varied as needed. Practical limits of minimum pitch (center-to-center) spacing are determined by (micro-bump) bonding technology, currently around 20 µm. The total size of the micoLED arrays CIS1, CIS2 may correspond to the illumination NA area, e.g., 50% (or two diagonally opposite quadrants) of the objective NA area ONA (e.g., having a diameter of 4 mm). In case of (de)magnifying optics, the objective NA area ONA can be larger or smaller.

MicroLED arrays are commercially available. A standard single microLED pixel is typically 20 µm in diameter. Devices can be fabricated in a cluster of single pixels creating collimated emitters up to 1 mm in diameter-or as arrays of individually addressable emitters. According to the state of the art, a single pixel can generate up to 1 mW, which results in a light intensity of more than 300 W/cm². Higher power can be achieved by using clusters of emitters. High powers may be accompanied with active cooling in close proximity to the emission region in order to maintain performance and lifetime of the devices.

In an alternative embodiment, the plurality of illumination sources (e.g., CIS1, CIS2) may be provided by one or more arrays of vertical cavity surface emitting lasers (VCSELs), wherein each VCSEL acts as one individually configurable illumination source. In another embodiment, the plurality of illumination sources (e.g., CIS1, CIS2) may be provided by one or more arrays of microLEDs and one or more arrays of VCSELs.

In an embodiment, the operating state and output characteristics of each of the plurality of individually configurable illumination sources (e.g., CIS1, CIS2) may be controllable e.g., by varying an input current to the illumination source. The operating state of an illumination source may comprise an ON state in which the illumination source is powered to emit illumination radiation IR, and an OFF state in which the illumination source is turned off. The characteristics of each individually configurable illumination source may comprise an output intensity, an output wavelength, an output bandwidth, and/or a polarization state.

In an embodiment, the illumination and detection arrangement IDA may further comprise one or more optical elements (e.g., optical filters, polarizing elements) configured to help control the output characteristics of each of the plurality of individually configurable illumination sources. In an embodiment, the illumination and detection arrangement IDA may further comprise one or more optical apertures configured to block undesired diffraction orders (e.g., zeroth diffraction order) while maximally transmitting desired diffraction orders (e.g., a positive first diffraction order (+1^{st} diffraction order) and a negative first diffraction order (-1^{st} diffraction order)).

With reference to Figures 6(a) and 6(c), in operation, some illumination sources of the first array CIS1 may be selectively activated (or switched on) to generate the illumination radiation IR having an illumination profile that substantially fills the first quadrant Z1 of the objective NA area ONA. The interaction of the illumination radiation IR provided by the first array CIS 1 with the structure S on the wafer W in the object plane OBP may result in scattering of the -1^{st} diffraction order -1(IR). The - 1^{st} diffraction order -1(IR) may be collected by the objective lens OB and propagate through the fourth quadrant Z4 of the objective NA area ONA before being detected by the second image sensor IM2.

Similarly, some illumination sources of the second array CIS2 may be selectively activated (or switched on) to generate the illumination radiation (not shown) having an illumination profile that substantially fills the third quadrant Z3 of the objective NA area ONA. The interaction of the illumination radiation provided by the second array CIS2 with the structure S on the wafer W in the object plane OBP may result in scattering of the +1^{st} diffraction order (not shown). The +1^{st} diffraction order may be collected by the objective lens OB and subsequently detected by the first image sensor IM1.

Figures 7(a)-7(c) are associated with a different embodiment where the illumination plane ILP is between the detection plane DTP and the object plane OBP when seen along a detection optical path, said detection optical path being the path that the scattered radiation (e.g., -1(IR)) from the structure S follows towards the at least one image sensor IM (e.g., as indicated by the dash double-dot line in Figure 7(a)). The main difference between the embodiment of Figures 6(a)-6(c) and the embodiment of Figures 7(a)-7(c) may lie in the detection part, e.g., the location of the image sensor IM and the detection plane DTP. As such, the same reference signs are used in both figures for the same or similar components. Figure 7(a) schematically illustrates a illumination and detection arrangement IDA' for a lithographic or inspection apparatus. Figure 7(b) shows an objective NA area ONA of the objective lens OB of the illumination and detection arrangement IDA'. Figure 7(c) shows an example arrangement of the individually configurable illumination sources and the at least one pair of optical wedges, both located in an illumination plane ILP which may be coplanar with the pupil plane of the objective lens OB.

In contrast to the illumination and detection arrangement IDA shown in Figures 6(a)-6(c), the illumination and detection arrangement IDA' shown in Figures 7(a)-7(c) may comprise no image sensors (e.g., IM1 and IM2 of IDA) in the illumination plane ILP. Instead, there may comprise at least one pair of optical wedges in the illumination plane ILP, which are configured to re-direct respectively the at least one portion of the scattered radiation (e.g., -1(IR)) in a first transverse direction (e.g., the x-direction) and in a second transverse direction (e.g., the y-direction) onto the at least one image sensor IM in the detection plane DTP. The at least one pair of optical wedges may be spatially separate from the plurality of individually configurable illumination sources and the first transverse direction and the second transverse direction may be orthogonal to each other.

The at least one pair of optical wedges may be arranged to re-direct the at least one portion of the scattered radiation (e.g., -1(IR)) after said scattered radiation has propagated through the detection NA area of the objective NA area ONA. Similar to the arrangement IDA shown in Figures 6(a)-6(c), the illumination NA area of the objective NA area ONA of the arrangement IDA' may consist of the two diagonally opposite quadrants Z1, Z3 of the objective NA area ONA and the detection NA area of the objective NA area ONA may consist of the other two diagonally opposite quadrants Z2, Z4 of the objective NA area ONA.

With continued reference to Figure 7(c), the plurality of the individually configurable illumination sources may comprise a first array of illumination sources CIS 1 which may be aligned with a first quadrant Z1 of the objective NA area ONA and a second array of illumination sources CIS2 which may be aligned with a third quadrant Z3 of the objective NA area ONA, the first quadrant Z1 and the third quadrant Z3 being diagonally opposite to each other. The at least one pair of optical wedges may comprise a first pair of optical wedges OWP1 which may be aligned with a second quadrant Z2 of the objective NA area ONA and a second pair of optical wedges OWP2 which may be aligned with a fourth quadrant Z4 of the objective NA area ONA, the second quadrant Z2 and the fourth quadrant Z4 being diagonally opposite to each other.

Referring back to Figure 7(a), the at least one portion of the scattered radiation may comprise a negative first diffraction order -1(IR) comprising a x-direction component and a y-direction component. The negative first diffraction order -1(IR) may result from interaction between the illumination radiation IR provided by the first array of illumination sources CIS 1 and the structure S. The at least one portion of the scattered radiation may comprise a positive first diffraction order (not shown) also comprising a x-direction component and a y-direction component. The positive first diffraction order may result from interaction between the illumination radiation provided by the second array of illumination sources CIS2 and the structure S. The first pair of optical wedges OWP1 may be configured to re-direct the x-direction component and the y-direction component of the negative first diffraction order -1(IR) onto one part (e.g., one quadrant) of the image sensor IM in the detection plane DTP. The second pair of optical wedges OWP2 may be configured to re-direct the x-direction component and the y-direction component of the positive first diffraction order onto another part (e.g., another quadrant that is diagonally opposite to the one for detecting the -1(IR)) of the image sensor IM in the detection plane DTP.

With continued reference to Figure 7(a), the illumination and detection arrangement IDA' may comprise one or more optical lenses OL between the illumination plane ILP and the detection plane DTP which may be configured to focus the re-directed at least one portion of the scattered radiation (e.g., the x-direction component and the y-direction component of the negative first diffraction order - 1(IR)) onto the corresponding part of the image sensor IM in the detection plane DTP.

Similar to the embodiment of Figures 6(a)-6(c), the first array of illumination sources CIS1, the second array of illumination sources CIS2, the first pair of optical wedges OWP1 and the second pair of optical wedges OWP2 may all be comprised in a single integral device/module. In such a case, the illumination and detection arrangement IDA' may further comprise a control unit (not shown) configured to control the operation of all the illumination sources (e.g., CIS1, CIS2) and (if desired) the movement of the optical wedges (e.g., OWP1, OWP2). The control unit may be comprised in the single integral device. Alternatively, the control unit may be part of a control system of a metrology tool in which the illumination and detection arrangement IDA' is comprised.

It will be appreciated that the one or more optical lenses OL and/or the at least one pair of optical wedges OWP1, OWP2 are not essential. Therefore, in some embodiments, the optical lenses OL or the optical wedge pairs OWP1, OWP2 may not be present. In other embodiments, both of the optical lenses OL and optical wedge pairs OWP1, OWP2 may not be present. As such, there may comprise no physical components in the corresponding areas (in which the optical wedge pairs are located OWP1, OWP2) of the illumination plane ILP. Thus, the at least one portion of the scattered radiation (e.g., - 1(IR)) may travel through the illumination plane ILP without its propagation direction being altered.

Similar to the embodiment of Figures 6(a)-6(c), each of the first array of illumination sources CIS 1 and the second array of illumination sources CIS2 of the arrangement IDA' may be of an array of microLEDs or an array of VCSELs, wherein each microLED or VCSEL acts as an individually configurable illumination source.

In an embodiment, the plurality of illumination sources of the arrangement IDA' may be provided by one or more transparent microLED (which may be inorganic LED or organic LED) panels, e.g., the first array of illumination sources CIS1 is provided by a first transparent microLED panel and the second array of illumination sources CIS2 is provided by a second transparent microLED panel. In a different embodiment, the plurality of illumination sources of the arrangement IDA' may be provided by a single transparent microLED panel. The single transparent microLED panel may comprise an area equal to, smaller or larger than the objective NA area. In such a configuration, the radiation (e.g., 0^{th} diffraction order, +1^{st} diffraction order, and -1^{st} diffraction order) scattered from the structure S may transmit through the transparent parts of the panel that are either outside or in-between LED pixels. Additional optical elements (e.g., apertures, optical masks, and/or optical wedges) may be placed behind the transparent microLED panel to direct the desired portion(s) (and optionally block the undesired portion(s)) of the scattered radiation having transmitted through the transparent parts of the panel to the image sensor IM in the detection plane DTP.

Above we discussed the hardware related aspects of the invention, but of course the invention also relates to a corresponding method for illuminating and detecting radiation in a metrology arrangement. The method is further described in this paragraph. Emitting illumination radiation from a plurality of individually configurable illumination sources located in an illumination plane, wherein each of the plurality of individually configurable illumination sources is operable to emit illumination radiation. Receiving the illumination radiation with an objective lens. Focusing the received illumination radiation onto a structure in an object plane with the objective lens. Collecting scattered radiation with the objective lens from the illuminated structure. Detecting at least one portion of the scattered radiation collected by the objective lens with at least one image sensor located in a detection plane, wherein the at least one portion of the scattered radiation either is detected at or passes through the illumination plane. Recording an image associated with the structure with the at least one image sensor.

Further embodiments are disclosed in the subsequent list of numbered clauses:
1. An illumination and detection arrangement for a metrology arrangement, comprising:
   a plurality of individually configurable illumination sources located in an illumination plane, wherein each of the plurality of individually configurable illumination sources is operable to emit illumination radiation;
   an objective lens defining an objective NA area and configured to receive the illumination radiation, focus it onto a structure in an object plane, and subsequently collect radiation scattered from the structure upon illumination; and
   at least one image sensor located in a detection plane and configured to detect at least one portion of the scattered radiation collected by the objective lens and record an image associated with the structure;
   wherein the at least one portion of the scattered radiation either is detected at or passes through the illumination plane.
2. An illumination and detection arrangement as defined in clause 1, wherein the objective NA area comprises an illumination NA area and a detection NA area.
3. An illumination and detection arrangement as defined in clause 2, wherein the illumination NA area comprises at least one portion of the objective NA area of the objective lens and the detection NA area comprises at least one portion of the objective NA area of the objective lens.
4. An illumination and detection arrangement as defined in clause 3, wherein the illumination NA area comprises at least one of two diagonally opposite portions of the objective NA area of the objective lens and the detection NA area comprises at least one of two other diagonally opposite portions of the objective NA area of the objective lens.
5. An illumination and detection arrangement as defined in clause 2 or 3 or 4, wherein the plurality of individually configurable illumination sources is configured such that an entire of the illumination NA area is fillable by the illumination radiation.
6. An illumination and detection arrangement as defined in any preceding clause, wherein the illumination plane is substantially coplanar with the detection plane and the plurality of individually configurable illumination sources is spatially separate from the at least one image sensor.
7. An illumination and detection arrangement as defined in clause 6, wherein the at least one image sensor is arranged to detect the at least one portion of the scattered radiation after it has propagated through the detection NA area.
8. An illumination and detection arrangement as defined in clause 6 or 7, wherein the plurality of the individually configurable illumination sources comprises a first array of illumination sources aligned with at least a first portion of the objective NA area and a second array of illumination sources aligned with at least a second portion of the objective NA area, the at least a first portion and the at least a second portion being diagonally opposite to each other.
9. An illumination and detection arrangement as defined in clause 8, wherein the at least a first portion and the at least a second portion comprise a first quadrant of the objective NA area and a second quadrant of the objective NA area, respectively.
10. An illumination and detection arrangement as defined in clause 8 or 9, wherein the first array of illumination sources covers a first area equal to or smaller or larger than that of the at least a first portion of the objective NA area, and the second array of illumination sources covers a second area equal to or smaller or larger than that of the at least a second portion of the objective NA area.
11. An illumination and detection arrangement as defined in clause 8 to 10, wherein the at least one image sensor comprises a first image sensor aligned with at least a third portion of the objective NA area and a second image sensor aligned with at least a fourth portion of the objective NA area, the at least a third portion and the at least a fourth portion being diagonally opposite to each other.
12. An illumination and detection arrangement as defined in clause 11, wherein the at least a third portion and the at least a fourth portion comprise a third quadrant of the objective NA area and a fourth quadrant of the objective NA area, respectively.
13. An illumination and detection arrangement as defined in clause 11 or 12, wherein the first image sensor covers a third area equal to or smaller or larger than that of the at least a third portion of the objective NA area and the second image sensor covers a fourth area equal to or smaller or larger than that of the at least a fourth portion of the objective NA area.
14. An illumination and detection arrangement as defined in any of clauses 6 to 13, wherein the plurality of individually configurable illumination sources and the at least one image sensor are comprised in a single integral device.
15. An illumination and detection arrangement as defined in any of clauses 1 to 5, wherein the illumination plane is between the detection plane and the object plane when seen along a detection optical path, said detection optical path being the path that the scattered radiation from the structure follows towards the at least one image sensor.
16. An illumination and detection arrangement as defined in clause 15, further comprising at least one pair of optical wedges located in the illumination plane and configured to re-direct respectively the at least one portion of the scattered radiation in a first transverse direction and in a second transverse direction onto the at least one image sensor in the detection plane, said first transverse direction and said second transverse direction being orthogonal to each other.
17. An illumination and detection arrangement as defined in clause 16, wherein the at least one pair of optical wedges is spatially separate from the plurality of individually configurable illumination sources in the illumination plane.
18. An illumination and detection arrangement as defined in clause 16 or 17, wherein the at least one pair of optical wedges is arranged to re-direct the at least one portion of the scattered radiation after it has propagated through the detection NA area of the objective NA area.
19. An illumination and detection arrangement as defined in clause 17 or 18, wherein the plurality of the individually configurable illumination sources comprises a first array of illumination sources aligned with a first quadrant of the objective NA area and a second array of illumination sources aligned with a second quadrant of the objective NA area, the first quadrant and the second quadrant being diagonally opposite to each other.
20. An illumination and detection arrangement as defined in clause 19, wherein the at least one pair of optical wedges comprises a first pair of optical wedges aligned with a third quadrant of the objective NA area and a second pair of optical wedges aligned with a fourth quadrant of the objective NA area, the third quadrant and the fourth quadrant being diagonally opposite to each other.
21. An illumination and detection arrangement as defined in any of clauses 15 to 20, wherein the plurality of individually configurable illumination sources and the at least one pair of optical wedges are comprised in a single integral device.
22. An illumination and detection arrangement as defined in any preceding clause, wherein the at least one portion of the scattered radiation comprises a positive first diffraction order and/or a negative first diffraction order.
23. An illumination and detection arrangement as defined in any preceding clause, wherein the plurality of individually configurable illumination sources is provided by one or more arrays of microLEDs, each microLED being one individually configurable illumination source.
24. An illumination and detection arrangement as defined in clause 23, wherein the one or more arrays of microLEDs are comprised in one or more transparent microLED panels.
25. An illumination and detection arrangement as defined in clause 23 or 24, wherein the plurality of individually configurable illumination sources is provided by a single transparent microLED panel configured to provide an illumination area equal to or smaller or larger than the objective NA area.
26. An illumination and detection arrangement as defined in any of clauses 1 to 22, wherein the plurality of individually configurable illumination sources is provided by one or more arrays of vertical cavity surface emitting lasers (VCSELs), each VCSEL being one individually configurable illumination source.
27. An illumination and detection arrangement as defined in any preceding clause, wherein each of the plurality of individually configurable illumination sources is configurable to change at least one or more of: an ON/OFF state, an output intensity, an output wavelength, and an output bandwidth.
28. A metrology device comprising an illumination and detection arrangement as defined in any preceding clause, operable to use the plurality of individually configurable illumination sources to provide measurement illumination for a measurement of a structure and use the at least one image sensor to record an image associated with the structure.
29. A metrology device as defined in clause 28, wherein the metrology device comprises a scatterometer, interferometer or holographic microscope.
30. A lithographic device comprising an illumination and detection arrangement as defined in any of clauses 1 to 27.
31. A method for illuminating and detecting radiation in a metrology arrangement, the method comprising:
   - emitting illumination radiation from a plurality of individually configurable illumination sources located in an illumination plane, wherein each of the plurality of individually configurable illumination sources is operable to emit illumination radiation;
   - receiving the illumination radiation with an objective lens;
   - focusing the received illumination radiation onto a structure in an object plane with the objective lens;
   - collecting scattered radiation with the objective lens from the illuminated structure;
   - detecting at least one portion of the scattered radiation collected by the objective lens with at least one image sensor located in a detection plane, wherein the at least one portion of the scattered radiation either is detected at or passes through the illumination plane;
   - recording an image associated with the structure with the at least one image sensor.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of an inspection or metrology apparatus, embodiments of the invention may be used in other apparatus. Embodiments of the invention may form part of a mask inspection apparatus, a lithographic apparatus, or any apparatus that measures or processes an object such as a wafer (or other substrate) or mask (or other patterning device). The term "metrology apparatus" may also refer to an inspection apparatus or an inspection system. E.g. the inspection apparatus that comprises an embodiment of the invention may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference may have been made above to the use of embodiments of the invention in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch P of the metrology targets may be close to the resolution limit of the optical system of the scatterometer or may be smaller, but may be much larger than the dimension of typical product features made by lithographic process in the target portions C. In practice the lines and/or spaces of the overlay gratings within the target structures may be made to include smaller structures similar in dimension to the product features.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An illumination and detection arrangement for a metrology arrangement, comprising:
a plurality of individually configurable illumination sources located in an illumination plane, wherein each of the plurality of individually configurable illumination sources is operable to emit illumination radiation;
an objective lens defining an objective NA area and configured to receive the illumination radiation, focus it onto a structure in an object plane, and subsequently collect radiation scattered from the structure upon illumination; and
at least one image sensor located in a detection plane and configured to detect at least one portion of the scattered radiation collected by the objective lens and record an image associated with the structure;
wherein the at least one portion of the scattered radiation either is detected at or passes through the illumination plane.

2. An illumination and detection arrangement as claimed in claim 1, wherein the objective NA area comprises an illumination NA area and a detection NA area.

3. An illumination and detection arrangement as claimed in claim 2, wherein the illumination NA area comprises at least one portion of the objective NA area of the objective lens and the detection NA area comprises at least one portion of the objective NA area of the objective lens.

4. An illumination and detection arrangement as claimed in claim 3, wherein the illumination NA area comprises at least one of two diagonally opposite portions of the objective NA area of the objective lens and the detection NA area comprises at least one of two other diagonally opposite portions of the objective NA area of the objective lens.

5. An illumination and detection arrangement as claimed in any preceding claim, wherein the illumination plane is substantially coplanar with the detection plane and the plurality of individually configurable illumination sources is spatially separate from the at least one image sensor.

6. An illumination and detection arrangement as claimed in claim 5, wherein the at least one image sensor is arranged to detect the at least one portion of the scattered radiation after it has propagated through the detection NA area.

7. An illumination and detection arrangement as claimed in claim 5 or 6, wherein the plurality of the individually configurable illumination sources comprises a first array of illumination sources aligned with at least a first portion of the objective NA area and a second array of illumination sources aligned with at least a second portion of the objective NA area, the at least a first portion and the at least a second portion being diagonally opposite to each other.

8. An illumination and detection arrangement as claimed in claim 7, wherein the at least a first portion and the at least a second portion comprise a first quadrant of the objective NA area and a second quadrant of the objective NA area, respectively.

9. An illumination and detection arrangement as claimed in claim 7 or 8, wherein the first array of illumination sources covers a first area equal to or smaller or larger than that of the at least a first portion of the objective NA area, and the second array of illumination sources covers a second area equal to or smaller or larger than that of the at least a second portion of the objective NA area.

10. An illumination and detection arrangement as claimed in claim 7 to 9, wherein the at least one image sensor comprises a first image sensor aligned with at least a third portion of the objective NA area and a second image sensor aligned with at least a fourth portion of the objective NA area, the at least a third portion and the at least a fourth portion being diagonally opposite to each other.

11. An illumination and detection arrangement as claimed in claim 10, wherein the at least a third portion and the at least a fourth portion comprise a third quadrant of the objective NA area and a fourth quadrant of the objective NA area, respectively.

12. An illumination and detection arrangement as claimed in any of claims 1 to 4, wherein the illumination plane is between the detection plane and the object plane when seen along a detection optical path, said detection optical path being the path that the scattered radiation from the structure follows towards the at least one image sensor.

13. An illumination and detection arrangement as claimed in any preceding claim, wherein the plurality of individually configurable illumination sources is provided by one or more arrays of microLEDs, each microLED being one individually configurable illumination source.

14. A method for illuminating and detecting radiation in a metrology arrangement, the method comprising:
- emitting illumination radiation from a plurality of individually configurable illumination sources located in an illumination plane, wherein each of the plurality of individually configurable illumination sources is operable to emit illumination radiation;
- receiving the illumination radiation with an objective lens;
- focusing the received illumination radiation onto a structure in an object plane with the objective lens;
- collecting scattered radiation with the objective lens from the illuminated structure;
- detecting at least one portion of the scattered radiation collected by the objective lens with at least one image sensor located in a detection plane, wherein the at least one portion of the scattered radiation either is detected at or passes through the illumination plane;
- recording an image associated with the structure with the at least one image sensor.

15. A metrology device comprising an illumination and detection arrangement as claimed in any of the claims 1 to 13, operable to use the plurality of individually configurable illumination sources to provide measurement illumination for a measurement of a structure and use the at least one image sensor to record an image associated with the structure.
